# EUROPÄISCHE PATENTSCHRIFT

(11) **EP 1 385 338 B1**
(45) Veröffentlichungstag und Bekanntmachung des Hinweises auf die Patenterteilung: **18.07.2007**
(21) Anmeldenummer: 02090276.3
(22) Anmeldetag: 23.07.2002
(51) Int. Cl.: H04N 9/31

(54) **Projektionsdisplay auf der Basis organischer Leuchtdioden**
Projection display based on organic light emitting diodes
Affichage par projection basé sur des diodes électroluminescentes organiques

(43) Veröffentlichungstag der Anmeldung: 28.01.2004
(73) Patentinhaber: Samsung SDI Co. Ltd., Suwon-city, Kyungki-do (KR)
(72) Erfinder: Redecker, Michael, Dr., 12524 Berlin (DE)
(74) Vertreter: Hengelhaupt, Jürgen

(56) Entgegenhaltungen:
- EP-A- 0 838 715
- EP-A- 0 869 388
- EP-A- 1 039 784
- PATENT ABSTRACTS OF JAPAN vol. 2000, no. 06, 22. September 2000 (2000-09-22) & JP 2000 066301 A (SEIKO EPSON CORP), 3. März 2000 (2000-03-03)

## Beschreibung

Die Erfindung betrifft ein Projektionsdisplay auf der Basis organischer Leuchtdioden und ein Verfahren zur Projektion von Bildern und Ähnlichem.

Projektionsdisplays finden zunehmend Anwendung in der Unterhaltungselektronik wie zum Beispiel in großformatigen Projektionsfernsehern.

Eine erste Generation von Projektionsdisplays wurde mit Kathodenstrahlröhren realisiert. Das auf einem Phosphorschirm durch Elektronenanregung erzeugte Zwischenbild wurde durch eine Optik auf eine Leinwand projiziert. Die erforderlichen Intensitäten sind für die verwendete Bildröhrentechnologie jedoch sehr anspruchsvoll und begrenzen die Lebensdauer. Zudem ist die Leistungsaufnahme hoch und die Projektionseinrichtgung relativ schwer und groß.

Heute werden hauptsächlich Projektionsdisplays auf der Basis von Flüssigkristallen eingesetzt. Die erforderliche Lichtquelle besteht dabei typischerweise aus einer Weißlichtlampe, deren Licht durch eine Flüssigkristall (LCD)-Matrix räumlich aufgelöst moduliert wird. Die erforderlichen Lichtfarben werden durch absorbierende Farbfilter erzeugt. Durch Farbmischung auf der reflektierenden bzw. transmittierenden Leinwand entsteht die erwünschte vergrößerte Abbildung.

Es ist weiterhin ein Verfahren bekannt, bei dem ein Array von Mikrospiegeln für die gewünschte Modulation des einfallenden Lichts sorgt. Wiederum sind Farbfilter für die Erzeugung der erwünschten Farben nötig.

Darüber hinaus ist die Anwendung von selbstemittierenden organischen Leuchtdioden (OLED) als Lichtquelle für Projektionsdisplays bekannt.
EP 0 838 715 A1 und EP 0 869 388 A1 beschreiben Projektionsdisplays, die organische Leuchtdioden als Lichtquelle nutzen. Die erforderliche Modulation der Lichtintensität wird durch eine vorgeschaltete Flüssigkristallmatrix erreicht. Die organische Leuchtdiode fungiert damit nicht als aktives Steuerelement, sondern nur als Lichtquelle, ähnlich einem Backlight in LCD-Anzeigen.
Nachteilig hieran ist, dass die durch Polarisator und Flüssigkristall entstehenden optischen Verluste durch eine entsprechende Helligkeit der organischen Leuchtdioden kompensiert werden müssen.

Der vorliegenden Erfindung liegt daher die Aufgabe zugrunde, ein Projektionsdisplay anzugeben, welches die vorgenannten Nachteile eliminiert.

Diese Aufgabe wird erfindungsgemäß gelöst durch die Merkmale im kennzeichnenden Teil des Anspruchs 1 (Vorrichtungsanspruch) und des Anspruchs 15 (Verfahrensanspruch) im Zusammenwirken mit den Merkmalen im Oberbegriff. Zweckmäßige Ausgestaltungen der Erfindung sind in den Unteransprüchen enthalten.

Ein besonderer Vorteil der Erfindung besteht darin, dass die Anzeigeelemente auf der Basis organischer Leuchtdioden als aktive Lichtsteuerelemente genutzt werden. Dazu werden die Leuchtdioden im so genannten Photolumineszenzlöschungsmodus betrieben. Die Funktionsweise des Photolumineszenzlöschungsmodus beruht auf dem Effekt, dass die Photolumineszenzemission eines organischen Materials durch ein angelegtes elektrisches Feld unterdrückt werden kann.
In einem ersten Schritt wird das Emittermaterial durch eine externe Lichtquelle optisch angeregt. Es bilden sich angeregte Zustände, die typischerweise nach einer Zeit von einigen Nanosekunden unter Aussendung von Photolumineszenzlicht zerfallen. Das dabei ausgesandte Licht besitzt eine Farbe, die für das jeweilige Emittermaterial charakteristisch ist. Ein weiterer Vorteil besteht darin, dass für ein solches Projektionsdisplay keine Farbfilter benötigt werden.

Durch Anlegen einer zusätzlichen Spannung kann ein elektrisches Feld in dem Emittermaterial erzeugt werden. Dieses Feld bewirkt die teilweise Aufspaltung der angeregten Zustände in Ladungsträger, bevor Photolumineszenzstrahlung emittiert werden kann. Dadurch wird die Konzentration angeregter Zustände herabgesetzt und als Konsequenz daraus die Intensität des Photolumineszenzlichts verringert. Somit besteht die Möglichkeit, die Intensität der Photolumineszenzstrahlung durch die angelegte Spannung zu steuern. Ohne angelegte Spannung ist die Intensität am höchsten, während sie unter angelegter Spannung reduziert wird.

Ein weiterer Vorteil ist, dass der Steuerstrom, der durch eine geeignete Treiberschaltung bereitgestellt werden muss, klein gehalten werden kann. Dies liegt daran, dass der Photolumineszenzlöschungsmodus bezüglich der Quanteneffizienz deutliche Vorteile aufweist. So wird pro gelöschter Anregung nur ein Ladungsträgerpaar erzeugt, das über die Kontakte abfließen muss. Das Licht einer Anregungslichtquelle wird auf ein Array aus organischen Leuchtdioden geleitet und regt die Anzeigenelemente des Arrays zum Aussenden von Photolumineszenzlicht an. Durch eine geeignete Treiberschaltung kann an jede organische Leuchtdiode eine Spannung angelegt werden, die dort zur Photolumineszenzlöschung führt. Das von dem Array emittierte Licht kann durch eine Projektionsoptik auf eine Leinwand bzw. einen transparenten Streuschirm projiziert werden.

Der Photolumineszenzlöschungsmodus erlaubt dabei das Erreichen ausreichender Helligkeit bei niedrigem benötigtem Strom, der durch das Anzeigenelement fließt.

Die Erfindung soll nachstehend anhand von zumindest teilweise in den Figuren dargestellten Ausführungsbeispielen näher erläutert werden.

Es zeigen:
- Fig. 1:: eine schematische Darstellung eines Projektionsdisplays im Photolumineszenzlöschungsmodus mit reflektierender Kathode und frontseitiger Einkopplung des Anregungslichts über die Anode,
- Fig. 2:: eine schematische Darstellung eines Projektionsdisplays im Photolumineszenzlöschungsmodus mit licht-transparenter Kathode und frontseitiger Einkopplung des Anregungslichts,
- Fig. 3:: eine schematische Darstellung eines Projektionsdisplays im Photolumineszenzlöschungsmodus mit rückseitiger Einkopplung des Anregungslichts über die Kathode,
- Fig. 4:: eine schematische Darstellung eines Projektionsdisplays im Photolumineszenzlöschungsmodus mit rückseitiger Einkopplung des Anregungslichts über die Anode.

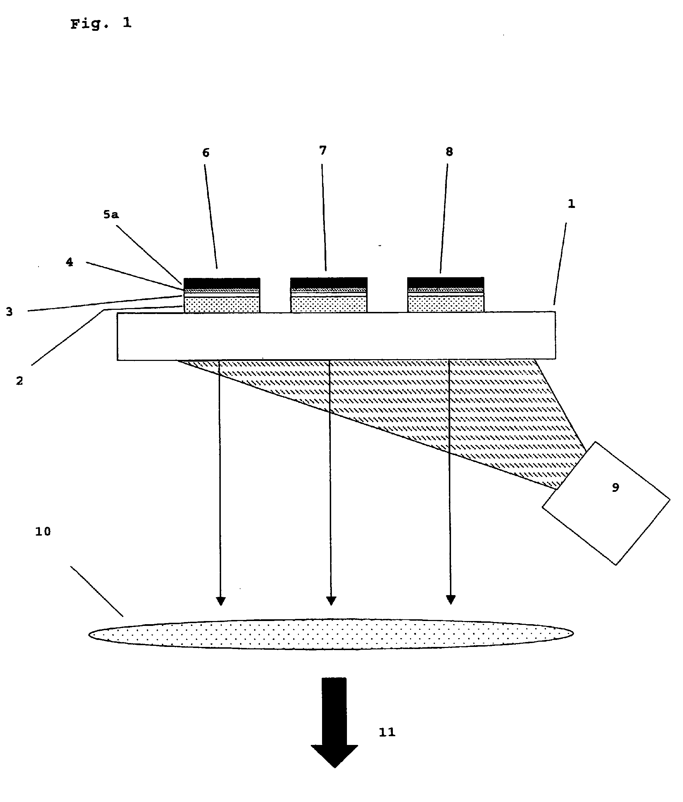

Fig. 1 zeigt eine bevorzugte Konfiguration für ein OLED-Projektionsdisplay im Photolumineszenzlöschungsmodus, bei dem das Anregungslicht an der Frontseite des OLED-Arrays eingekoppelt wird. Das Anregungslicht wird in den Unterpixeln für Rot 6, Grün 7 und Blau 8 in Form von Photolumineszenzlicht in die jeweilige Farbe konvertiert und wieder abgestrahlt. Die emittierte Photolumineszenzstrahlung wird durch eine Projektionsoptik 10 auf eine Leinwand abgebildet. Durch Anlegen einer Spannung zwischen transparenter Anode 2 und reflektiver Kathode 5 kann die abgestrahlte Lichtmenge für jeden Unterpixel gesteuert werden. Eine geeignete Treiberschaltung für die Helligkeitssteuerung ist eine Dünnfilmtransistorschaltung, die mittels polykristallinem oder monokristallinem Silizium realisiert werden kann und pro Unterpixel einmal benötigt wird. Durch Zusammenschalten entsteht eine aktive Treibermatrix. Die Vorrichtung weist zusätzlich eine Lochtransportschicht 3 auf. Für diese Lochtransportschicht 3 können Dispersionen von Poly(ethylendioxythiophen)/Polystyrolsulfonsäure und Polyanilin verwendet werden. Für die Emitterpolymere kommen speziell Polymere aus den Materialklassen der Polyphenylenvinylene und der Polyfluorene in Betracht.

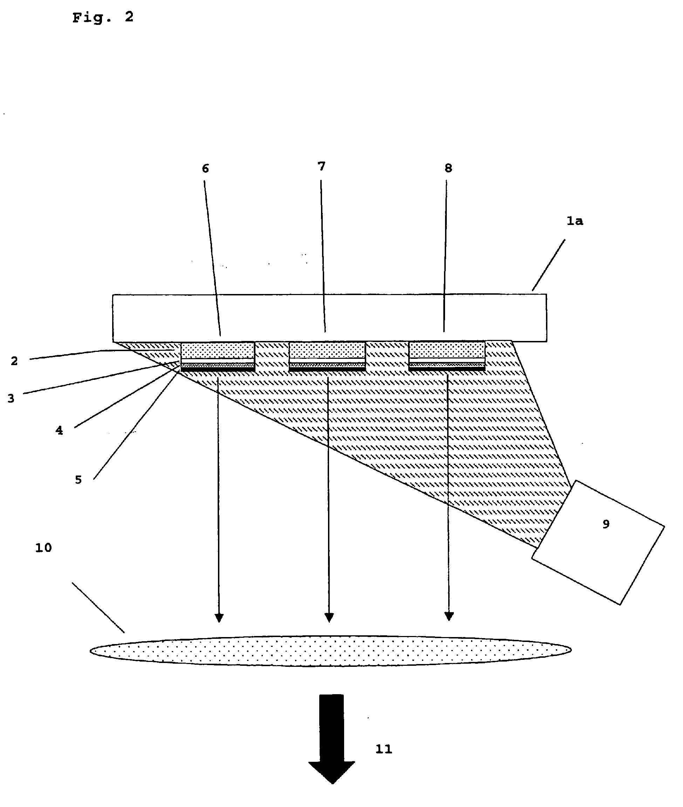

In Fig. 2 ist ein zweites bevorzugtes Ausführungsbeispiel dargestellt. Das Anregungslicht wird wiederum auf der Emissionsseite des Displays eingekoppelt. In diesem Fall kann jedoch ein nichttransparentes Substrat verwendet werden, da die Ein- und Auskopplung von Licht durch einen transparenten Kontakt erfolgt. Insbesondere kann monokristallines Silizium als Substratmaterial verwendet werden. Die erforderliche Treiberelektronik kann somit direkt in das Displayelement integriert werden.
Der Vorteil dieser Anwendung liegt insbesondere in den hohen Treiberströmen, die aufgrund der hohen Ladungsträgerbeweglichkeit in monokristallinem Silizium erreicht werden können. Damit einher geht eine hohe erreichbare Helligkeit des Displays.

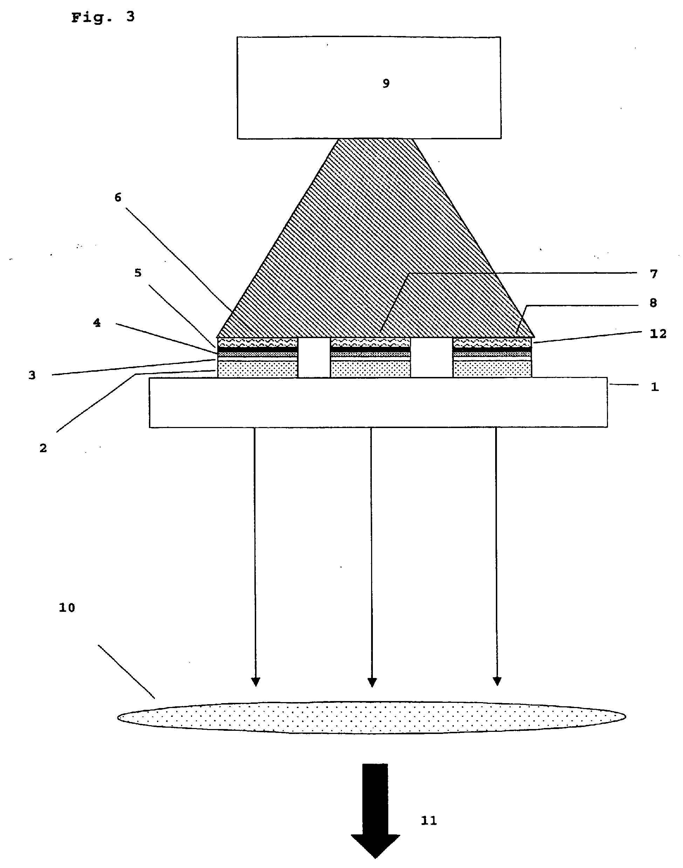

Fig. 3 zeigt eine schematische Darstellung eines Projektionsdisplays im Photolumineszenzlöschungsmodus mit rückseitiger Einkopplung des Anregungslichts über die Kathode. Das von der Rückseite eingekoppelte Licht passiert einen schmalbandigen dielektrischen Spiegel, der hohe Reflektivität bei der jeweiligen Emissionswellenlänge der OLED besitzt. Im Falle des roten Unterpixels wird also rotes Licht stark reflektiert, während das von der Lampe kommende Licht ungehindert durchgelassen wird.
Es werden bevorzugt Lampen mit einem hohen Anteil an blauem und ultraviolettem Licht verwendet. Dabei kommen bevorzugt Gasentladungslampen, wie Quecksilber- und Xexonlampen, in Betracht. Die Spiegelschicht kann durch Aufbringen von Multischichten mit stark unterschiedlichem Brechungsindex hergestellt werden, wobei die optische Weglänge einer Schicht ein Viertel der Reflexionswellenlänge beträgt.
Geeignete Materialien mit niedrigem Brechungsindex sind zum Beispiel Siliziumdioxyd, Siliziumnitrid, Magnesiumfluorid und verwandte Materialien.

Geeignete Materialien mit hohem Brechungsindex sind zum Beispiel Titandioxyd, Zinnoxyd, Zirkonoxyd und Tantaloxyd. Auf den dielektrischen Spiegel folgt eine transparente Kathodenschicht. Geeignete Materialkombinationen sind zum Beispiel unedle Metalle wie Kalzium, Magnesium, Barium und Aluminium, die in dünner Schicht auf die Emitterschicht aufgebracht werden und die zur Erhöhung der Leitfähgikeit mit einer Schicht eines leitfähigen transparenten Materials wie zum Beispiel Indium-Zinnoxid (ITO) bedeckt werden. Als zusätzliche Schichten können Metallfluoride wie Lithiumfluorid, Bariumfluorid oder Magnesiumfluorid zwischen der Emitterschicht und dem Kathodenmetall integriert werden. Die Dicke der ITO-Schicht kann so gewählt werden, dass sie die erste Schicht des dielektrischen Spiegels darstellt.

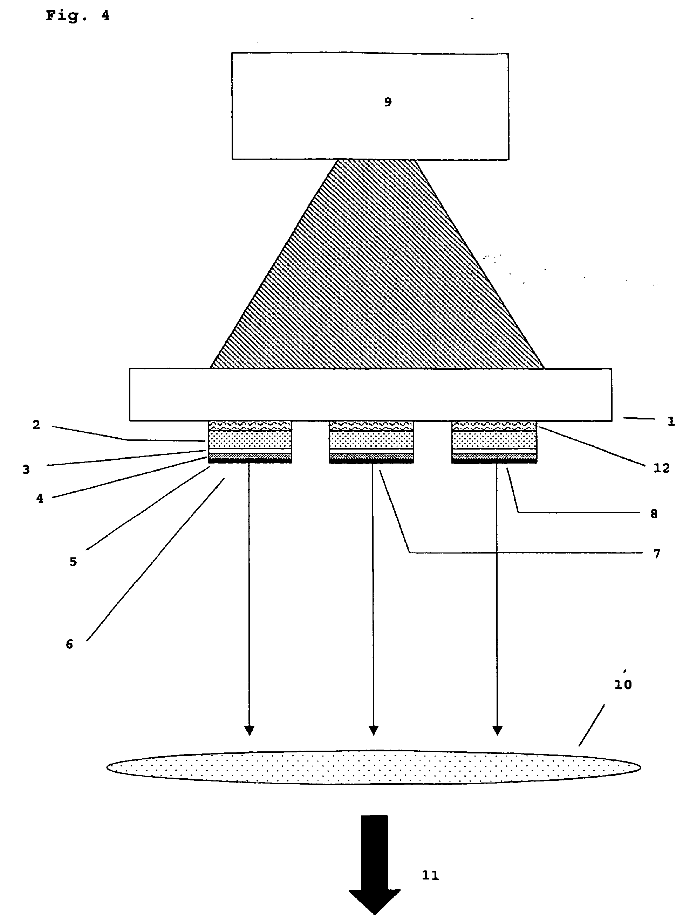

Fig. 4 zeigt eine schematische Darstellung eines Projektionsdisplays im Photolumineszenzlöschungsmodus mit rückseitiger Einkopplung des Anregungslichts über die Anode. Diese ist auf einem entsprechenden dielektrischen Spiegel aufgebaut. Diese Symmetrie hat gegenüber Fig. 2 den Vorteil, dass die Strukturierungsprozesse für den Spiegel und den Anodenkontakt auf dem Substrat erfolgen können, bevor organische Schichten aufgebracht werden, die empfindlich auf die Prozessbedingungen der Strukturierung reagieren. Außerdem ist es hier möglich, den dielektrischen Spiegel aus leitfähigen polymeren Materialien aufzubauen. Die Emission von Photolumineszenzlicht erfolgt durch die transparente Kathodenschicht.

Alle gezeigten Strukturen können mit zusätzlichen Maßnahmen zur Verbesserung der Licht Ein- und Auskopplung erweitert werden. Dazu gehören unter anderem Mikrolinsen auf der Einund Austrittsseite sowie reflexionsmindernde Schichten. Zusätzlich ist die Verwendung eines Sperrfilters für den Wellenlängenbereich der Anregungslichtquelle möglich. Dieser Filter wird auf der Lichtaustrittsseite angebracht. Idealerweise handelt es sich dabei ebenfalls um einen dielektrischen Spiegel, der das Licht der Anregungslichtquelle zurückwirft und damit die Lichtausbeute zusätzlich verbessert.

In Fig. 3 und 4 kann dieser Filter direkt in das Anzeigenelement integriert werden, in Fig. 1 und 2 muss genügend Abstand von dem Anzeigenelement eingehalten werden, um die Einkopplung des Anregungslichtes zu gewährleisten.

Die Erfindung ist nicht beschränkt auf die hier dargestellten Ausführungsbeispiele, vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Substrat
- 1a: transparentes Substrat
- 2: transparenter leitfähiger Kontakt mit hoher Elektronen-Austrittsarbeit
- 2a: reflektierender leitfähiger Kontakt mit hoher Elektronen-Austrittsarbeit
- 3: Lochtransportschicht
- 4: Emitterschicht
- 5: transparenter Kontakt mit niedriger Elektronen-Austrittsarbeit
- 5a: reflektiver Kontakt mit niedriger Elektronen-Austrittsarbeit
- 6: roter Unterpixel
- 7: grüner Unterpixel
- 8: blauer Unterpixel
- 9: Anregungslichtquelle
- 10: Projektionsoptik
- 11: Richtung zur Projektionsleinwand
- 12: dielektrischer Spiegel

## Patentansprüche

1. Projektionsdisplay auf Basis organischer lichtemittierender Elemente, **dadurch gekennzeichnet, dass** die organischen lichtemittierenden Materialien (4) zwischen zwei Elektroden (2, 2a, 5, 5a) angeordnet und mittels einer Anregungslichtquelle (9) zu einer Photolumineszenzemission anregbar sind und dass über diese Elektroden (2, 2a, 5, 5a) ein elektrisches Feld zur Steuerung des Photolumineszenz-Löschungeffektes anlegbar ist.

2. Projektionsdisplay nach Anspruch 1, **dadurch gekennzeichnet, dass** die organischen lichtemittierenden Elemente (6, 7, 8) sowohl im emissiven Modus zur Umwandlung von Signalspannungen in elektromagnetische Wellen als auch im reemissiven Modus zur Unterdrückung einer Photolumineszenzemission schaltbar sind.

3. Projektionsdisplay nach Anspruch 1 oder 2, **dadurch gekennzeichnet, dass** dieses ein Array von organischen lichtemittierenden Elementen (6, 7, 8) aufweist, welche Licht unterschiedlicher Wellenlängen emittieren können.

4. Projektionsdisplay nach Anspruch 1 bis 3, **dadurch gekennzeichnet, dass** die organischen lichtemittierenden Materialien (4) einerseits niedermolekulare organische Emittermaterialien oder andererseits lichtemittierende polymere Materialien sind, wobei die lichtemittierenden polymeren Materialien speziell aus den Materialklassen der Polyphenylenvinylene und der Polyfluorene stammen.

5. Projektionsdisplay nach Anspruch 1 bis 4, **dadurch gekennzeichnet, dass** die organischen lichtemittierenden Elemente zusätzlich eine Lochtransportschicht (3) aufweisen, die aus Dispersionen von Poly(ethylendioxythiophen)/ Polystyrolsulfonsäure und Polyanilin besteht.

6. Projektionsdisplay nach Anspruch 1 bis 5, **dadurch gekennzeichnet, dass** die Anregungslichtquelle (9) Lampen mit einem hohen Anteil an blauem und ultravioletten Licht wie Quecksilberlampen und/oder Xenonlampen verwendet werden.

7. Projektionsdisplay nach Anspruch 1 bis 6, **dadurch gekennzeichnet, dass** die Spannung für das elektrische Feld über eine Treiberschaltung angelegt wird, welche eine Dünnfilm-Transistorschaltung ist, die aus polykristallinem oder monokristallinem Silizium besteht.

8. Projektionsdisplay nach Anspruch 1 bis 7, **dadurch gekennzeichnet, dass** das emittierte Licht über eine Projektionsoptik (10) auf eine Projektionsleinwand oder einen Streuschirm abgebildet wird.

9. Projektionsdisplay nach Anspruch 1 bis 8, **dadurch gekennzeichnet, dass** die lichtemittierenden organischen Elemente (6, 7, 8) auf einem Substrat (1) angeordnet sind, wobei das Substrat (1) aus monokristallinem Silizium besteht.

10. Projektionsdisplay nach Anspruch 1 bis 9, **dadurch gekennzeichnet, dass** die Kathode (5, 5a) aus Kalzium oder Magnesium oder Barium oder Aluminium besteht und zusätzliche Hilfsschichten aus Metallfluoriden wie Lithiumfluorid, Bariumfluorid oder Magnesiumfluorid enthalten kann.

11. Projektionsdisplay nach Anspruch 1 bis 10, **dadurch gekennzeichnet, dass** dieses zusätzlich einen dielektrischen Spiegel (12) aufweist, welcher ein schmalbandiger Spiegel für den Wellenlängenbereich des emittierten Lichts der organischen lichtemittierenden Materialien (4) ist.

12. Projektionsdisplay nach Anspruch 11, **dadurch gekennzeichnet, dass** der dielektrische Spiegel (12) aus Multischichten mit stark unterschiedlicher Brechzahl besteht, wobei Siliziumdioxyd, Siliziumnitrid oder Magnesiumfluorid für niedrige Brechzahlen und Titandioxyd, Zinnoxyd, Zirkonoxyd oder Tantaloxyd für hohe Brechzahlen verwendet werden.

13. Projektionsdisplay nach Anspruch 1 bis 12, **dadurch gekennzeichnet, dass** dieses zusätzlich Vorrichtungen zur Verbesserung der Ein- und Auskopplung des Lichts wie Mikrolinsen und/oder reflexionsmindernde Schichten aufweist.

14. Projektionsdisplay nach Anspruch 1 bis 13, **dadurch gekennzeichnet, dass** dieses zusätzlich einen Sperrfilter für die Wellenlänge der Anregungslichtquelle (9) aufweist.

15. Verfahren zur Projektion durch Modulation und optische Abbildung einer Anregungslichtquelle (9), welches folgende Schritte umfaßt:
- Anregung von organischen lichtemittierenden Materialien (4) zu einer Photolumineszenzemission,
- gleichzeitige Steuerung der Photolumineszenzemission mittels Photolumineszenzlöschung durch Erzeugen eines elektrischen Feldes in den organischen lichtemittierenden Materialien (4),
- Abbildung des emittierten Lichts.

16. Verfahren nach Anspruch 15, **dadurch gekennzeichnet, dass** die organischen lichtemittierenden Materialien (4) einerseits niedermolekulare organische Emittermaterialien oder andererseits lichtemittierende polymere Materialien sind, wobei die lichtemittierenden polymeren Materialien speziell aus den Materialklassen der Polyphenylenvinylene und der Polyfluorene stammen.

17. Verfahren nach Anspruch 15 oder 16, **dadurch gekennzeichnet, dass** die Spannung für das elektrische Feld über eine Treiberschaltung angelegt wird, welche eine Transistorschaltung aus polykristallinem oder monokristallinem Silizium ist.

18. Verfahren nach Anspruch 15 bis 17, **dadurch gekennzeichnet, dass** das emittierte Licht über eine Projektionsoptik (10) auf eine Projektionsleinwand oder einen Streuschirm abgebildet wird.

## Claims

1. Projection display on the basis of organic light-emitting elements, **wherein** the organic light-emitting materials (4) are arranged between two electrodes (2, 2a, 5, 5a) and can be excited to a photoluminescence emission by means of an excitation light source (9) and that, by way of these electrodes (2, 2a, 5, 5a), an electric field for controlling the photoluminescence quenching effect can be applied.

2. Projection display according to Claim 1, **wherein** the organic light-emitting elements (6, 7, 8) are switchable both in the emissive mode for conversion of signal voltages into electromagnetic waves as well as in the re-emissive mode for the suppression of a photo luminescence emission.

3. Projection display according to Claim 1 or 2, **wherein** this has an array of organic light-emitting elements (6, 7, 8) which can emit light of different wavelengths.

4. Projection display according to Claims 1 to 3, **wherein** the organic light-emitting materials (4) are, on the one hand, low-molecular organic emitter materials or, on the other hand, are light-emitting polymer materials, where the light-emitting polymer materials specially originate from the material classes of the polyphenylene vinylene and the polyfluorene.

5. Projection display according to Claims 1 to 4, **wherein** the light-emitting elements additionally have a hole transport layer (3) which consists of dispersions of poly(ethylene dioxy thiophene) / polystyrene sulfone acid and polyaniline.

6. Projection display according to Claims 1 to 5, **wherein** lamps with a high quota of blue and ultraviolet light such as mercury lamps and/or xenon lamps are used as the excitation light source (9).

7. Projection display according to Claims 1 to 6, **wherein** the voltage for the electric field is applied by way of a driver circuit which is a thin film transistor circuit consisting of polycrystalline or monocrystalline silicon.

8. Projection display according to Claims 1 to 7, **wherein** the emitted light is imaged by way of a projection optic unit (10) onto a projection screen or a diffusing screen.

9. Projection display according to Claims 1 to 8, **wherein** the light-emitting organic elements (6, 7, 8) are arranged on a substrate (1), where the substrate (1) consists of monocrystalline silicon.

10. Projection display according to Claims 1 to 9, **wherein** the cathode (5, 5a) consists of calcium or magnesium or barium or aluminium and can contain additional auxiliary layers made from metal fluorides such as lithium fluoride, barium fluoride or magnesium fluoride.

11. Projection display according to Claims 1 to 10, **wherein** this has in addition a dielectric mirror (12) which is a narrow band mirror for the wavelength range of the emitted light of the organic light-emitting materials (4).

12. Projection display according to Claims 1 to 11, **wherein** the dielectric mirror (12) consists of multi-layers with a greatly differing refractive number, where silicon dioxide, silicon nitride or magnesium fluoride are used for low refractive numbers and titanium dioxide, tin oxide, zirconium oxide or tantalic oxide are used for high refractive numbers.

13. Projection display according to Claims 1 to 12, **wherein** this has in addition devices for the improvement of injection-coupling and de-coupling of the light such as micro lenses and/or reflection-reducing layers.

14. Projection display according to Claims 1 to 13, **wherein** this has in addition a rejection filter for the wavelength of the excitation light source (9) .

15. Method for the projection by means of modulation and optic imaging of an excitation light source (9), which comprises the following steps:
-- Excitation of organic light-emitting materials (4) to a photo luminescence emission,
-- Simultaneous control of the photo luminescence emission by means of photo luminescence quenching by the generation of an electric field in the organic light-emitting materials (4),
-- imaging of the emitted light.

16. Method according to Claim 15, **wherein** the organic light-emitting materials are, on the one hand, low-molecular organic emitter materials or, on the other hand, are light-emitting polymer materials (4), where the light-emitting polymer materials specially originate from the material classes of the polyphenylene vinylene and the polyfluorene.

17. Method according to Claims 15 or 16, **wherein** the voltage for the electric field is applied by way of a driver circuit which is a transistor circuit made of polycrystalline or moncrystalline silicon.

18. Method according to Claims 15 to 17, **wherein** the emitted light is imaged by way of a projection optic unit (10) onto a projection screen or a diffusing screen.

## Revendications

1. Affichage par projection à base d'éléments luminescents organiques, **caractérisé en ce que** les matières luminescentes organiques (4) sont disposées entre deux électrodes (2, 2a, 5, 5a) et peuvent être excitées au moyen d'une source de lumière d'excitation (9) pour produire une émission de photoluminescence et **en ce que** l'on peut appliquer, par l'intermédiaire de ces électrodes (2, 2a, 5, 5a), un champ électrique servant à commander l'effet d'extinction de photoluminescence.

2. Affichage par projection selon la revendication 1, **caractérisé en ce que** les éléments luminescents organiques (6, 7, 8) sont commutables non seulement en mode émissif pour convertir des tensions de signal en ondes électromagnétiques, mais aussi en mode réémissif pour retenir une émission de photoluminescence.

3. Affichage par projection selon la revendication 1 ou 2, **caractérisé en ce que** celui-ci comporte un groupement d'éléments luminescents organiques (6, 7, 8) qui peuvent émettre de la lumière de différentes longueurs d'onde.

4. Affichage par projection selon les revendications 1 à 3, **caractérisé en ce que** les matières luminescentes organiques (4) sont, d'une part, des matières émissives organiques de faible poids moléculaire ou, d'autre part, des matières polymères luminescentes, les matières polymères luminescentes faisant spécialement partie des catégories de matières que sont les polyphénylènes vinylènes et les polyfluorènes.

5. Affichage par projection selon les revendications 1 à 4, **caractérisé en ce que** les éléments luminescents organiques comportent, de plus, une couche de transport de trous (3) qui est faite de dispersions de poly(éthylène dioxythiophène) / acide polystyrène sulfonique et de polyaniline.

6. Affichage par projection selon les revendications 1 à 5, **caractérisé en ce qu'**on utilise, comme source de lumière d'excitation (9), des lampes à proportion élevée de lumière bleue et ultraviolette telles que des lampes au mercure et/ou des lampes au xénon.

7. Affichage par projection selon les revendications 1 à 6, **caractérisé en ce que** la tension du champ électrique est appliquée par l'intermédiaire d'un circuit d'attaque qui est un circuit à transistors à couche mince qui est fait de silicium polycristallin ou monocristallin.

8. Affichage par projection selon les revendications 1 à 7, **caractérisé en ce que** la lumière émise est représentée, par l'intermédiaire d'une optique de projection (10), sur un écran de projection ou sur un panneau diffuseur.

9. Affichage par projection selon les revendications 1 à 8, **caractérisé en ce que** les éléments luminescents organiques (6, 7, 8) sont disposés sur un substrat (1), le substrat (1) étant fait de silicium monocristallin.

10. Affichage par projection selon les revendications 1 à 9, **caractérisé en ce que** la cathode (5, 5a) est faite de calcium, de magnésium, de baryum ou d'aluminium et peut comprendre des couches auxiliaires supplémentaires faites de fluorures métalliques tels que le fluorure de lithium, le fluorure de baryum ou le fluorure de magnésium.

11. Affichage par projection selon les revendications 1 à 10, **caractérisé en ce que** celui-ci comporte, de plus, un miroir diélectrique qui est un miroir à bande étroite (12) destiné à la gamme de longueur d'ondes de la lumière émise par les matières luminescentes organiques (4).

12. Affichage par projection selon la revendication 11, **caractérisé en ce que** le miroir diélectrique (12) se compose de couches multiples ayant un indice de réfraction très différent, auquel cas on utilise du dioxyde de silicium, du nitrure de silicium ou du fluorure de magnésium pour les indices de réfraction bas et du dioxyde de titane, de l'oxyde d'étain, de l'oxyde de zirconium ou de l'oxyde de tantale pour les indices de réfraction élevés.

13. Affichage par projection selon les revendications 1 à 12, **caractérisé en ce que** celui-ci comporte, de plus, des dispositifs servant à améliorer le couplage et le découplage de la lumière, tels que des microlentilles et/ou des couches réduisant la réflexion.

14. Affichage par projection selon les revendications 1 à 13, **caractérisé en ce que** celui-ci comporte, de plus, un filtre d'arrêt destiné à la longueur d'onde de la source de lumière d'excitation (9).

15. Procédé de projection par modulation et représentation optique d'une source de lumière d'excitation (9), lequel comprend les étapes suivantes:
- excitation de matières luminescentes organiques (4) en vue de produire une émission de photoluminescence ;
- commande simultanée de l'émission de photoluminescence par extinction de photoluminescence en produisant un champ électrique dans les matières luminescentes organiques (4) ;
- représentation de la lumière émise.

16. Procédé selon la revendication 15, **caractérisé en ce que** les matières luminescentes organiques (4) sont, d'une part, des matières émissives organiques de faible poids moléculaire ou, d'autre part, des matières polymères luminescentes, les matières polymères luminescentes faisant spécialement partie des catégories de matières que sont les polyphénylènes vinylènes et les polyfluorènes.

17. Procédé selon la revendication 15 ou 16, **caractérisé en ce que** la tension du champ électrique est appliquée par l'intermédiaire d'un circuit d'attaque qui est un circuit à transistors en silicium polycristallin ou monocristallin.

18. Procédé selon les revendications 15 à 17, **caractérisé en ce que** la lumière émise est représentée, par l'intermédiaire d'une optique de projection (10), sur un écran de projection ou sur un panneau diffuseur.
